# EUROPÄISCHE PATENTSCHRIFT

(11) **EP 2 745 389 B1**
(45) Veröffentlichungstag und Bekanntmachung des Hinweises auf die Patenterteilung: **05.12.2018**
(21) Anmeldenummer: 11766959.8
(22) Anmeldetag: 29.09.2011
(51) Int. Cl.: H02M 7/00, H02M 1/32

(54) **STAPELFÄHIGER LEISTUNGSHALBLEITERSCHALTER MIT LÖT-BONDTECHNIK**
STACKABLE POWER SEMICONDUCTOR SWITCH WITH BOND WIRES
COMMUTATEUR SEMI-CONDUCTEUR DE PUISSANCE EMPILABLE AVEC CONNEXIONS PAR FILS

(43) Veröffentlichungstag der Anmeldung: 25.06.2014
(73) Patentinhaber: Siemens Aktiengesellschaft, 80333 München (DE); Infineon Technologies Bipolar GmbH & Co. KG, 59581 Warstein (DE)
(72) Erfinder: DORN, Jörg, 96155 Buttenheim (DE); HUANG, Hartmut, 91056 Erlangen (DE)
(86) Internationale Anmeldenummer: PCT/EP2011/067021
(87) Internationale Veröffentlichungsnummer: WO 2013/044966

(56) Entgegenhaltungen:
- EP-A2- 0 785 625
- WO-A1-2006/104430
- WO-A1-2010/081555
- WO-A1-2010/102654
- CN-A- 101 819 970
- DE-A1- 19 839 422
- US-A1- 2007 145 540
- Markus Billmann ET AL: "Explosion proof housings for IGBT module based high power inverters in HVDC transmission application", Journal of Electrical and Computer Engineering, 12 May 2009 (2009-05-12), pages 352-357, XP055484972, ISSN: 2090-0147
- KAUFMANN S ET AL: "Innovative press pack modules for high power IGBTs", PROCEEDINGS OF THE 13TH. INTERNATIONAL SYMPOSIUM ON POWER SEMICONDUCTOR DEVICES & ICS. ISPSD'01. OSAKA, JAPAN, JUNE 4 - 7, 2001; [INTERNATIONAL SYMPOSIUM ON POWER SEMICONDUCTOR DEVICES & IC'S], NEW YORK, NY : IEEE, US, 4 June 2001 (2001-06-04), pages 59-62, XP010551570, DOI: 10.1109/ISPSD.2001.934559 ISBN: 978-4-88686-056-9

## Beschreibung

Die Erfindung betrifft eine Schaltungseinheit für einen Umrichter mit einem Leistungshalbleiterschalter, der wenigstens einen Kollektoranschluss, wenigstens einen Emitteranschluss als Lastanschlüsse und einen Steueranschluss aufweist, wobei in einem Halbleitergehäuse angeordnete Leistungshalbleiterchips über Bonddrähte, die zum Führen von Laststrom ausgelegt sind, miteinander verbunden sind und einen über den Steueranschluss steuerbaren Strompfad zwischen den Lastanschlüssen bereitstellen, wobei der Leistungshalbleiterschalter von seiner Durchlassstellung, in der ein Stromfluss zwischen den Lastanschlüssen in einer Durchlassrichtung ermöglicht ist, in seine Sperrstellung oder umgekehrt überführt wird, in der ein Stromfluss zwischen den Lastanschlüssen unterbrochen ist.

Leistungshalbleiterschalter werden beispielsweise in leistungselektrischen Anlagen der Energieübertragung und -verteilung eingesetzt.

Bei der Hochspannungsgleichstromübertragung oder so genannten Flexible AC Transmission Systems (FACTS) spielen mehr und mehr selbstgeführte Umrichter eine Rolle. Selbstgeführte Umrichter weisen Leistungshalbleiter mit Abschaltfähigkeit wie beispielsweise IGBTs, GTOs, IGCTs oder dergleichen auf. Die ein- und abschaltbaren Leistungshalbleiter liegen im Falle von IGBTs als Leistungshalbleiterchips vor, die wiederum zu Leistungshalbleiterschaltern verbaut sind. Die Leistungshalbleiterschalter werden aufgrund der hohen Spannungen im Bereich der Energieübertragung in der Regel in Reihenschaltungen eingesetzt. Der Ausfall eines einzelnen Leistungshalbleiters oder der dazugehörigen Elektronik darf aufgrund von Verfügbarkeitsanforderungen nicht zu einer Abschaltung der gesamten Anlage oder des Systems führen. Deshalb werden in den besagten Reihenschaltungen redundante Levels eingebaut. Bei einem solchen Level handelt es sich beispielsweise um einen einzelnen Leistungshalbleiterschalter mit zugehöriger Freilaufdiode, Ansteuer- und Überwachungselektronik. Im Falle von Multi-Level-Umrichtern kann ein solches Level durch Submodule realisiert sein, die jeweils einen eigenen Energiespeicher und eine hierzu parallele Leistungshalbleiterschaltung aufweisen.

Entscheidend für die Erzielung einer Redundanz ist die Eigenschaft, dass nach Ausfall eines Levels ein niederohmiger Strompfad anstelle des defekten Levels zur Verfügung stehen muss. Nur Leistungshalbleiter mit spezieller Aufbautechnik besitzen in der Regel diese Eigenschaften, die im Englischen als "Conduct on Fail" bezeichnet wird. Druckkontaktierte Bauelemente, die im Englischen als "Press-pack" bezeichnet werden, weisen diese Fähigkeit innerhalb gewisser Stromgrenzen auf.

Nachteilig ist der hohe mechanische Aufwand zur Herstellung der druckkontaktierten Bauelemente wie Scheibenzellenhalbeiter, so dass diese Komponenten teuer sind. Entsprechend gering ist die Anzahl der Hersteller der Bauelemente. Druckkontaktierte IGBTs sind beispielsweise von der Firma Toshiba oder der Firma Westcode kommerziell erhältlich. Auch das Unternehmen ABB stellt druckkontaktierte IGBTs her.

Die in den Anlagen der Energieübertragung und -verteilung heute überwiegend eingesetzten IGBT-Bausteine haben die gemeinsame Eigenschaft, dass eine Reihe von kleinflächigen Chips parallel geschaltet ist, um die erforderliche Stromtragfähigkeit zu erreichen. Als industrieller Standard hat sich im Gegensatz zu druckkontaktierten IGBT-Bauelementen dabei die Modulbauform etabliert, bei der die Chips mit einer Seite auf ein Substrat gelötet werden und auf der anderen Seite mit Bonddrähten kontaktiert sind.

Da sich bei Ausfall eines Chips der gesamte Laststrom zunächst auf diesen ausgefallenen Chip konzentriert, werden die mit diesem ausgefallen Chip verbundenen Bonddrähte durch den Laststrom überlastet, so dass diese schmelzen können mit der Ausbildung eines Lichtbogens und der Explosion des gesamten Leistungshalbleiterschalters im Gefolge. Die industrieüblichen IGBT-Schalter mit Lötbondtechnik besitzen daher nicht die inhärente Eigenschaft, bei ihrer Zerstörung eine niederohmige Verbindung auszubilden, so dass eine Überbrückung des fehlerhaften Bauteils bereitgestellt ist. Aus diesem Grunde sind bei einem Einsatz dieser Leistungshalbleiterschalter in Anlagen der Energieübertragung und -verteilung zusätzliche Maßnahmen erforderlich.

Bei einem so genannten modularen Multi-Level-Umrichter unter Verwendung industrieüblicher Leistungshalbleiterschalter mit Löt-Bond-Technik wird der niederohmige Strompfad zur Überbrückung eines fehlerhaften Submoduls mit Hilfe eines mechanischen Bypassschalters realisiert, wobei die Auslösung über eine Detektion des Überschreitens eines Spannungsniveaus oder eines Gradienten der Spannung des zugehörigen Submodulkondensators erfolgt. Nachteilig an dieser Lösung ist jedoch die relativ aufwändige Elektronik zur Versorgung und Erfassung zum Nachweis und zum Auslösen des Bypassschalters. Werden in Umrichtern mit Zwei- oder Dreipunkttechnik oder mit einer Multileveltopologie statt eines einzelnen Leistungshalbleiterschalters mehrere Leistungshalbleiterschalter in Reihe geschaltet, ist eine derartige Erfassung zur Auslösung eines Bypasses oder Überbrückungsschalters an einem einzelnen Leistungshalbleiterschalter nicht möglich, da eine Zwischenkreisentladung wegen der restlichen fehlerfreien Leistungshalbleiterschalter der Reihenschaltung wunschgemäß nicht erfolgt. Die bisherige Messtechnik zur Überwachung und Überbrückung des Fehlers kann daher bei einer solchen Reihenschaltung nicht mehr eingesetzt werden. Aus diesem Grunde kommen bislang nur die oben beschriebenen kostenintensiven druckkontaktierten Bauelemente mit ihrer inhärenten "Conduct on Fail"-Eigenschaft zum Einsatz.

Einige der aus dem Stand der Technik bekannten druckkontaktierten Leistungshalbleiter weisen ferner die Eigenheit auf, dass diese aufeinander gestapelt werden können, wobei die Lastanschlüsse im Stapel aufeinander folgender Leistungshalbleiterschalter ohne weitere Verbindungsleitungen in elektrischem Kontakt miteinander stehen.

Die Lastanschlüsse der vorbekannten gattungsgemäßen Leistungshalbleiteschalter sind jedoch auf der gleichen Seite des Gehäuses angeordnet, in dem die Leistungshalbleiterchips angeordnet sind. Eine Reihenschaltung kann daher nicht durch einfaches Stapeln der besagten Leistungshalbleiter erfolgen.

Aus der Offenlegungsschrift WO2010/081555A1 ist ein Umrichter mit Schalteinheiten bekannt, die jeweils eine leitende Platte mit einer Mehrzahl von auf dieser Platte montierten Halbleiterchips aufweisen. Die Schalteinheiten sind elektrisch in Reihe geschaltet, wobei die Halbleiterchips einer Schalteinheit jeweils mittels eines Bonddrahtes mit der leitenden Platte der benachbarten Schalteinheit leitend verbunden sind.

Aus der Offenlegungsschrift US 2007/0145540A1 ist ein Halbleiterelement bekannt, das in einem Gehäuse zwei Halbleiterchips aufweist. Zur elektrischen Verbindung zum Außenraum des Gehäuses sind drei das Gehäuse durchdringende Anschlüsse vorgesehen, die im Inneren des Gehäuses mittels Bonddrähten kontaktiert sind.

In der Offenlegungsschrift DE 198 39 422 A1 wird ein stapelbares Schaltermodul mit Explosionsschutz offenbart. Die inneren Details werden nicht offenbart und lediglich angemerkt, dass es im wesentlichen den Aufbau des ABB IGBT Press-Pack Moduls aufweist. Ein Aufbau mit industrieüblichen Modulen wird ebenfalls gezeigt, allerdings nicht in Form eines Stapel- und verspannbaren Moduls.

Aufgabe der Erfindung ist es, eine Schaltungseinheit der eingangs genannten Art bereitzustellen, die also einen in der Industrie üblichen kostengünstigen Leistungshalbleiterschalter mit Bonddrähten aufweist, die unter Ausbildung einer Reihenschaltung mit identischen Schaltungseinheiten gestapelt werden kann, wobei die Lastanschlüsse ohne weitere Zwischenleiter über einen Druckkontakt direkt miteinander verbunden sind.

Die Erfindung löst diese Aufgabe durch eine Reihenschaltung gemäß dem Patentanspruch 1. Dabei ist der Leistungshalbleiterschalter zwischen einer elektrisch mit den Emitteranschlüssen verbundenen Emitterplatte und einer elektrisch mit den Kollektoranschlüssen verbundenen Kollektorplatte angeordnet, wobei die Emitterplatte und die Kollektorplatte elektrisch leitend und über ein Zwischenbauteil aneinander abgestützt sind, das einen Stromfluss zwischen Emitterplatte und Kollektorplatte in wenigstens einer Richtung verhindert.

Erfindungsgemäß ist ein für Industrieanwendungen ausgelegter und beispielsweise in der Antriebstechnik üblicher Leistungshalbleiter zwischen zwei elektrisch leitfähigen Platten angeordnet, wobei die beiden Platten einmal mit dem oder den Emitteranschlüssen und einmal mit dem Kollektoranschluss des Leistungshalbleiterschalters verbunden sind. Die besagten Lastanschlüsse sind somit mit stapelfähigen Platten verbunden. Dabei bildet die Emitterplatte den Emitteranschluss und die Kollektorplatte den Kollektoranschluss der erfindungsgemäßen Schaltungseinheit aus. Die Schaltungseinheit weist somit zwei Lastanschlüsse auf, die an voneinander abgewandte Seiten der Schaltungseinheit angeordnet sind. Erfindungsgemäße Schaltungseinheiten können daher gestapelt und miteinander verspannt werden. Zum Verspannen der gestapelten Schalteinheiten dienen Spannmittel, die beispielsweise aus der Thyristortechnik bekannt sind. Erfindungsgemäß ist somit ein "Pseudo-Press-Pack" bereitgestellt. Die elektrische Verbindung zwischen den Lastanschlüssen des Leistungshalbleiterschalters und der Kollektor- bzw. Emitterplatte erfolgt beispielsweise durch zweckmäßige Verbindungsleitungen oder Verschienung.

Der oder die Leistungshalbleiter der erfindungsgemäßen Schaltungseinheit verfügt über steuerbare Leistungshalbleiterchips mit Chiplastanschlüssen. Der Stromfluss zwischen den Chiplastanschlüssen ist über Steuersignale, die an einem Gate- oder Steueranschluss der Chips anliegen steuerbar. Die eingesetzten Bonddrähte des Leistungshalbleiters dienen zur Verbindung der Chiplastanschlüsse der Chips im Leistungshalbleiterschalter.

Vorteilhafterweise ist das Zwischenbauteil als elektrisch isolierende umfängliche geschlossene Seitenwand ausgestaltet, so dass Emitterplatte, Kollektorplatte und Seitenwand ein geschlossenes Schaltungsgehäuse ausbilden. Die Seitenwand besteht beispielsweise aus einem formfesten Isolierstoff, so dass neben der Isolations- und der druckaufnehmenden Wirkung der Seitenwand auch ein Explosionsschutz bereitgestellt ist.

Abweichend hiervon ist das Zwischenbauteil als wenigstens eine Scheibenzellendiode ausgestaltet die gegensinnig parallel zur Durchlassrichtung des Leistungshalbleiters geschaltet ist. Gemäß dieser Variante der Erfindung kann der Leistungshalbleiterschalter ausschließlich steuerbare Leistungshalbleiterchips aufweisen. Die als Freilaufdioden wirkenden Diodenchips sind in Gestalt der Scheibenzellendiode außerhalb des Halbleitergehäuses angeordnet. Hierbei weisen alle steuerbaren Leistungshalbleiterchips eine gemeinsame Durchlassrichtung auf, so dass eine Steuerung des Stromflusses in dieser Richtung ermöglicht ist. Die nicht steuerbare Durchlassrichtung der oder jeder Scheibenzellendiode ist entgegengesetzt zur Durchlassrichtung der steuerbaren Leistungshalbleiterchips des Leistungshalbleiters ausgerichtet, wobei jede Scheibenzellendiode parallel zum Leistungshalbleiterschalter geschaltet ist. Jede Scheibenzellendiode ist somit eine druckkontaktierte Freilaufdiode für den industrieüblichen Leistungshalbleier. Ein Stromfluss von Emitter- zur Kollektorplatte erfolgt daher ausschließlich über druckkontaktierte Bauteile, so dass in dieser Richtung ohne weitere Maßnahmen die oben beschriebene Conduct on Fail-Eigenschaft bereit gestellt ist. Zweckmäßigerweise ist die Scheibenzellendiode mit einer elastischen und elektrisch leitenden Deformationsschicht ausgerüstet. Die elastisch verformbare Deformationsschicht verhindert eine Zerstörung der jeweiligen Scheibenzellendiode, wenn die Schaltungseinheiten miteinander verspannt werden. Hierzu weist die Deformationsschicht eine geeignete Elastizität auf. Beispielsweise besteht die Deformationsschicht aus Kupfer und weist eine zweckmäßige Dicke auf, die von dem Druck der Verspannung und den konstruktiven Erfordernissen abhängig ist.

Gemäß einer diesbezüglich zweckmäßigen Weiterentwicklung ist eine elektrisch isolierende und umfänglich geschlossene Seitenwand vorgesehen, deren Höhe kleiner ist als die Höhe der Scheibenzellendiode, wobei Emitterplatte, Kollektorplatte und Seitenwand ein Schaltungsgehäuse ausbilden. Gemäß diesem Ausführungsbeispiel nimmt oder nehmen die Scheibenzellendiode(n) weiterhin den Druck beim Verspannen auf. Gleichzeitig ist jedoch ein Gehäuse bereit gestellt, das einen Schutz vor Verunreinigungen oder Explosionen bereitstellt. Zum spannungsfreien Halten der Seitenwand weisen die Emitter- und Kollektorplatte vorteilhafterweise geeignete Haltemittel, in Gestalt von Haltenuten, frei gebogenen Halteschultern oder dergleichen auf.

Gemäß einer weiteren Variante der Erfindung verfügt das Halbleitergehäuse über eine elektrisch leitende Basisplatte, wobei jeder Leistungshalbleiterchip zwei Chiplastanschlüsse aufweist und mit einem seiner Chiplastanschlüsse elektrisch leitend mit der Basisplatte verbunden ist, so dass die Basisplatte einen der Lastanschlüsse des Leistungshalbleiterschalters ausbildet. Gemäß dieser Variante der Erfindung wird ein zweckmäßig veränderter gebondeter Leistungshalbleiterschalter eingesetzt. Dieser weist Lastanschlüsse auf, die an voneinander abgewandten Gehäuseseiten des Halbleitergehäuses angeordnet sind. Somit ist es möglich, den Leistungshalbleiterschalter mit seiner Basisplatte direkt mit einer der Platten der Schaltungseinheit zu verbinden. Zweckmäßigerweise ist die Basisplatte mit der Kollektorplatte verbunden, beispielsweise verschraubt. Der Emitteranschluss des Leistungshalbleiters ist hingegen mit geeigneten elektrischen Verbindungsleitungen an die Emitterplatte angeschlossen.

Bei einer vorteilhaften Ausgestaltung dieser Variante der erfindungsgemäßen Schaltungseinheit ist jeder Leistungshalbleiterchip flächig mit der Basisplatte oder mit einer elektrisch leitenden Zwischenschicht verbunden, die im elektrischen Kontakt mit der Basisplatte steht. Der Leistungshalbleiterchip kann hierzu mit einer beliebigen Methode flächig mit der Basisplatte direkt oder mit der Zwischenschicht verbunden werden. Vorteilhafterweise ist der Leistungshalbleiterchip flächig aufgelötet.

Zweckmäßigerweise sind Kühlmittel zum Kühlen der Leistungshalbleiterchips vorgesehen. Hiezu erstrecken sich beispielsweise Kühlrohre durch die Kollektor- und/oder Emitterplatte. Diese steht beispielsweise in Wärme leitendem flächigem Kontakt mit einer Basisplatte. Die Kühlrohre sind beispielsweise aus einem leitenden oder nicht leitenden Material gefertigt, das jedoch eine zur Kühlung ausreichende Wärmeleitfähigkeit aufweist. Abweichend hiervon sind in der Kühlplatte rohrförmige Bohrungen ausgebildet, wobei die elektrisch nicht leitenden Kühlrohre fluiddicht mit den Bohrungen verbunden sind. Als Kühlungsfluid eignet sich beispielsweise deionisiertes Wasser. Abweichend hiervon können sich die Kühlrohre jedoch auch durch die Basisplatte selbst erstrecken, die dann auch als Kühlplatte wirkt. Natürlich kann auch die Basisplatte rohrförmige Bohrungen aufweisen.

Gemäß einer bevorzugten Variante der Erfindung sind Kurzschlussmittel vorgesehen, die zum Kurzschließen der Emitterplatte und der Kollektorplatte im Fehlerfall eingerichtet sind. Die Kurzschlussmittel schaffen eine erfindungemäße Schalteinheit mit einer "Conduct on Fail" Eigenschaft bei Bedarf für beide Stromrichtungen.

Vorteilhafterweise weisen die Kurzschlussmittel neben zweckmäßigen Auslösemitteln einen Überbrückungsschalter auf. Der Überbrückungsschalter überbrückt im geschlossenen Zustand Emitterplatte und Kollektorplatte. Als Überbrückungsschalter kommt ein mechanischer Schalter, oder ein elektronischer Schalter wie beispielsweise ein Thyristor in Betracht. Als mechanischer Schalter dient beispielsweise ein Schalter mit pyrotechnischem Antrieb. Die Zündung des Überbrückungsschalters erfolgt durch geeignete Auslösemittel. Beispielsweise detektieren die Auslösemittel eine unsymmetrische Stromverteilung im Leistungshalbleiterschalter in der Folge der Beschädigung von Leistungshalbeiterschips.

Vorteilhafterweise sind die Kurschlussmittel zwischen der Emitterplatte und der Kollektorplatte angeordnet. Hierbei bilden Emitterplatte und Kollektorplatte beispielsweise ein Schaltungsgehäuse aus, wobei die Kurzschlussmittel zumindest teilweise in dem Schaltungsgehäuse angeordnet sind. Das Schaltungsgehäuse stellt einen Schutz vor Verunreinigungen und im Bedarfsfall auch gegenüber Explosionen im Inneren des Schaltungsgehäuses bereit. Beispielsweise sind die Auslösemittel innerhalb des Schaltungsgehäuses angeordnet, während der Überbrückungsschalter außerhalb angeordnet ist. Abweichend hiervon ist auch der Kurschlussschalter innerhalb des Schaltungsgehäuses angeordnet. Der Kurzschlussschalter ist beispielsweise ein mechanischer Schalter, wie z.B. ein Vakuumschalter, mit pyrotechnischem Antrieb. Abweichend hiervon ist der Kurzschlussschalter ein elektromagnetisch angetriebener Schalter oder ein elektronischer Schalter und z.B. ein Thyristor. Das Schaltungsgehäuse kann gasdicht ausgebildet und mit einem Schutzgas befüllt sein. Dies verringert die einzuhaltenden Kontaktabstände des mechanischen Schalters und führt zu einem schnelleren Schließen des Schalters.

Gemäß einer bevorzugten Variante bildet der Leistungshalbleiterschalter wenigstens zwei parallel zueinander geschaltete Leistungshalbleitersegmente aus, die jeweils zwei Lastanschlüsse in Gestalt des Kollektor- und Emitteranschlusses aufweisen, wobei Mittel zur Erfassung einer unsymmetrischen Verteilung des Stromes auf die Lastanschlüsse vorgesehen sind. Gemäß dieser Variante der Erfindung sind die Auslösemittel zum Auslösen des Schalters durch Mittel zur Erfassung einer unsymmetrischen Verteilung des Stromes auf die Lastanschlüsse des Leistungshalbleiterschalters realisiert. Hierdurch ist eine einfache Fehlererfassung auch bei in Reihe geschalteten Leistungshalbleiterschaltern möglich, so dass eine gezielte Überbrückung der fehlerhaften Leistungshalbleiterschalter der Reihenschaltung, also im Stapel, ermöglicht ist. Darüber hinaus ist eine Erfassungs- und Auslösevorrichtung bereitgestellt, die keine eigene Energieversorgung benötigt oder jedenfalls mit sehr geringen Leistungen auskommt, um die zur Fehlerüberwachung notwendigen Bauteile mit Energie zu versorgen. Die Leistungshalbleitersegmente bilden parallel zueinander geschaltet und weitestgehend unabhängige Strompfade aus. Dabei verfügt jedes Leistungshalbleitersegment über seine eigenen zwei Lastanschlüsse, nämlich den Kollektoranschluss sowie den Emitteranschluss, wobei die Kollektor- oder bevorzugt die Emitteranschlüsse elektrisch miteinander verbunden sein können. In diesem Falle sind die Mittel zur Erfassung einer unsymmetrischen Verteilung des Stromes an den nicht elektrisch miteinander verbundenen Lastanschlüssen angeordnet. So ist der Gesamtkollektoranschluss des Leistungshalbleiterschalters segmentweise aufgeteilt in die parallel zueinander geschalteten Kollektoranschlüsse der einzelnen Leistungshalbleitersegmente, von denen gemäß dieser Variante der Erfindung wenigstens zwei vorhanden sein müssen, um die Möglichkeit zu haben, eine Unsymmetrie des Stromflusses auf die einzelnen Segmente feststellen zu können.

Vorteilhafterweise weisen die Mittel zur Erfassung einer unsymmetrischen Stromverteilung eine Messeinheit mit wenigstens einem Messsensor auf, die zur Erfassung eines Stromflusses über wenigstens zwei Lastanschlüsse oder zur Erfassung einer aus dem besagten Stromfluss abgeleiteten Größe eingerichtet ist.

Vorteilhafterweise kommen als Messsensoren Stromwandler, Rogowski-Spulen und/oder ein Hallsensoren in Betracht. Diese Sensoren sind dem Fachmann bekannt, so dass eine ausführlichere Beschreibung ihrer Wirkungsweise an dieser Stelle entfallen kann.

Weiterhin ist gemäß einer weiteren Ausführungsvariante der Erfindung jeder Messsensor zur Erfassung des Stromflusses an einem zugeordneten Lastanschluss des Leistungshalbleiterschalters vorgesehen. Mit anderen Worten verfügt jedes Leistungshalbleitersegment über wenigstens einen oder zwei Messsensoren, der bzw. die diesem fest zugeordnet sind. Der Messsensor erfasst den Stromfluss beispielsweise an der Zuleitung des Emitteranschlusses des zugeordneten Segments. Die Messsignale der Messsensoren der Emitter- oder der Kollektoranschlüsse werden miteinander verglichen, wobei im Falle des Auftretens einer Unsymmetrie oder einer Unsymmetrie, die einen zuvor festgelegten Schwellenwert überschreitet, auf das Vorliegen eines Fehlers geschlossen wird und anschließend beispielsweise ein Bypassschalter zum Überbrücken des jeweiligen Leistungshalbleiterschalters geschlossen wird.

Zweckmäßigerweise entspricht die Anzahl der Messsensoren einer geraden ganzen Zahl, wobei die Messsensoren in zwei Hälften aufgeteilt und die Signale der Messsensoren der einen Hälfte mit entgegen gesetztem Vorzeichen den Signalen der Messsensoren der anderen Hälfte aufaddiert werden. Mit dieser vorteilhaften Ausgestaltung der Erfindung vereinfacht sich der für die Auswertung erforderliche Aufwand mit noch geringeren Kosten im Gefolge. Gemäß dieser vorteilhaften Ausgestaltung kommt es bei einer symmetrischen Stromverteilung auf die Leistungshalbleitersegmente und somit auf die einzelnen Lastanschlüsse zu einer Addition der Messsignale zu Null. Übersteigt hingegen die Summe der Messsignale der Messsensoren einen zuvor festgelegten Schwellenwert, kann auf das Vorliegen eines Leistungshalbleiterfehlers geschlossen werden. Die Aufaddierung der Messsensorsignale kann beispielsweise durch zweckmäßige Verschaltung der Messsensoren erzielt werden, wobei der Schwellenwert durch eine Auslösemechanik in die Praxis umgesetzt wird, die über eine gewisse Ansprechträgheit verfügt. Die Verschaltung, also beispielsweise Parallel- oder Reihenschaltung der Messsensoren, ist von der Art der eingesetzten Messsensoren abhängig. Das unterschiedliche Vorzeichen der Messsignale kann durch unterschiedliche Wicklungsrichtungen der Messspulen der Messsensoren erreicht werden.

Vorteilhafterweise ist an jedem Kollektoranschluss und/oder an jedem Emitteranschluss ein Messsensor angeordnet. Beispielsweise sind 2n Leistungshalbleitersegmente in dem Leistungshalbleiterschalter ausgebildet, wobei n eine ganze Zahl ist. Bei vier Leistungshalbleitersegmenten wären beispielsweise die beiden Kollektoranschlüsse mit jeweils einem Messsensor ausgerüstet, wobei die jeweiligen Messsignale mit unterschiedlichen Vorzeichen miteinander aufsummiert werden. Dies kann auch parallel dazu auch an dem jeweiligen Emitteranschluss erfolgen, wobei die Messsignale der Messsensoren mit gegensinnigem Vorzeichen aufaddiert werden, die an den beiden Emitteranschlüssen angeordnet sind. Abweichend hiervon ist es jedoch auch möglich, jeweils einen Messsensor an dem Kollektoranschluss des einen Leistungshalbleitersegments und an dem Emitteranschluss des anderen Leistungshalbleitersegmentes anzuordnen, wobei die Messsignale der beiden Messsensoren mit unterschiedlichen Vorzeichen einander aufaddiert werden.

Gemäß einer weiteren Variante der Erfindung umfassen die Mittel zur Erfassung einer unsymmetrischen Stromverteilung ein weichmagnetisches Joch und wenigstens einen Messsensor, der zum Erfassen eines magnetischen Feldes in dem weichmagnetischen Joch eingerichtet ist. Gemäß dieser vorteilhaften Weiterentwicklung wird ein weichmagnetisches Joch eingesetzt, um eine von Stromflüssen abgeleitete Größe, in diesem Fall ein magnetisches Feld zu bündeln. Diese Bündelung verringert den messtechnischen Aufwand. Dabei umschließt das weichmagnetische Joch zweckmäßigerweise ein oder mehrere Paare von Lastanschlüssen in der Weise, dass bei einer symmetrischen Stromverteilung auf die von den weichmagnetischen Joch umschlossenen Lastanschlüssen, die sich im weichmagnetischen Joch einstellenden Magnetfelder jedenfalls in einem messtechnisch überwachten Abschnitt des Jochs gegenseitig auslöschen. Erst bei einer asymmetrischen oder mit anderen Worten unsymmetrischen Stromverteilung kommt es zu einem Ansteigen des Magnetfeldes im weichmagnetischen Joch oder in dessen überwachten Abschnitt und somit zu einer nachweisbaren Größe, die beispielsweise von einer einzigen Messspule eines Messsensors, die um einen Schenkel des weichmagnetischen Jochs gewickelt ist, erfasst werden kann. Da nicht mehr Messsensoren für jedes Leistungshalbleitersegment, sondern nur noch ein Messsensor benötigt wird, sind die Kosten verringert.

Zweckmäßigerweise umgibt das weichmagnetische Joch Lastanschlüsse paarweise. Beispielweise umgibt das Joch einen Kollektoranschluss des einen Leistungshalbleitersegments sowie einen Emitteranschluss eines anderen Leistungshalbleitersegments. Abweichend davon umfasst das weichmagnetische Joch zwei Emitteranschlüsse paralleler Leistungshalbleitersegmente sowie zwei Kollektoranschlüsse von anderen parallelen Leistungshalbleitersegmenten. Es ist in diesem Zusammenhang auch möglich, dass das weichmagnetische Joch vier Emitteranschlüsse von vier Leistungshalbleitersegmenten umschließt. Selbstverständlich können auch Zwischenstege an dem weichmagnetischen Joch ausgebildet sein, so dass jeweils zwei Kollektor- oder Emitteranschlüsse des Leistungshalbleiterschalters von den gleichen Schenkeln des weichmagnetischen Joches umschlossen sind. Bei dieser Variante löschen sich die Magnetfelder bei Normalbetrieb nur in dem Verbindungssteg gegenseitig aus. An dem Verbindungssteg ist der Messsensor angeordnet.

Vorteilhafterweise bestehen die Leistungshalbleiterchips aus steuerbaren Leistungshalbleiterchips und gegensinnig parallelen Diodenchips, wobei die steuerbaren Leistungshalbleiterchips und Diodenchips in voneinander unabhängige Leistungshalbleitersegmente unterteilt sind, wobei jedes Leistungshalbleitersegment einen Kollektoranschluss und einen Emitteranschluss sowie einen Steuerungsanschluss aufweist. Abweichend hiervon weist der Leistungshalbleiterschalter nur steuerbare Leistungshalbleiterchips, die ein- und abgeschaltet werden können, und bevorzugt IGBT-Chips auf.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleichwirkende Bauteile verweisen und wobei
- Figur 1: einen vorbekannten Leistungshalbleiterschalter in Modulbauweise mit Löt-Bond-Technik,
- Figur 2: die Verschaltung eines Leistungshalbleiterchips des Leistungshalbleiterschalters gemäß Figur 1,
- Figur 3: einen vorbekannten Press-Pack-IGBT-Chip,
- Figur 4: eine Schaltungseinheit für die erfindungsgemäße Reihenschaltung in einer Seitenansicht,
- Figur 5: eine weitere Schaltungseinheit für die erfindungsgemäße Reihenschaltung in einer Draufsicht,
- Figur 6: eine weitere Schaltungseinheit für die erfindungsgemäße Reihenschaltung in einer Draufsicht,
- Figur 7: ein Leistungshalbleiterchip eines Leistungshalbleiterschalters einer Schaltungseinheit für die erfindungsgemäße Reihenschaltung,
- Figur 8: einen Leistungshalbleiterschalter für eine Schaltungseinheit für die erfindungsgemäße Reihenschaltung in perspektivischer Ansicht,
- Figur 9: eine weitere Schaltungseinheit für die erfindungsgemäße Reihenschaltung in einer Draufsicht,
- Figur 10: eine weitere Schaltungseinheit für die erfindungsgemäße Reihenschaltung in einer Seitenansicht,
- Figur 11: eine weitere Schaltungseinheit für die erfindungsgemäße Reihenschaltung in einer Seitenansicht und
- Figur 12: ein Ausführungsbeispiel einer erfindungsgemäßen Reihenschaltung von Schaltungseinheiten zeigen.

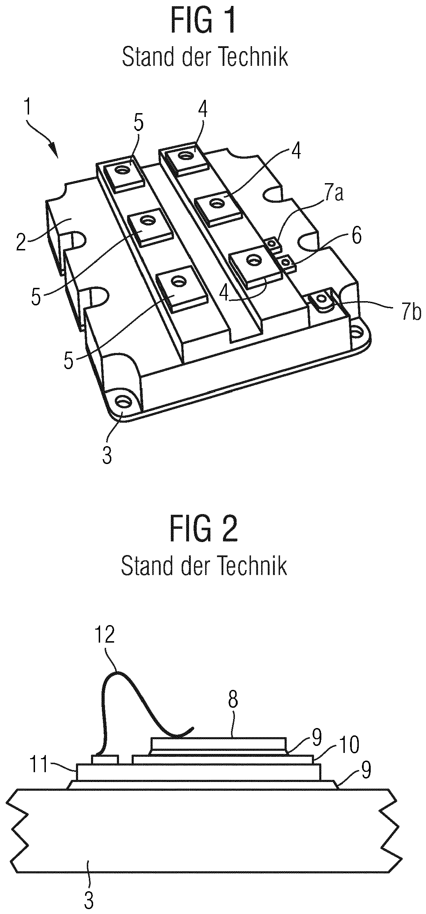

Figur 1 zeigt einen Leistungshalbleiterschalter 1 gemäß dem Stand der Technik in perspektivischer Ansicht, der auch als Leistungshalbleitermodul bezeichnet wird. Es ist erkennbar, dass der Leistungshalbleiterschalter 1 ein Halbleitergehäuse 2 aufweist, das aus einem nicht leitenden isolierenden Material besteht und mit einer metallischen Basisplatte 3 verbunden ist. An seiner Oberseite weist der Leistungshalbleiterschalter 1 drei Emitteranschlüsse 4 sowie drei Kollektoranschlüsse 5 auf, die aus dem Halbleitergehäuse 2 herausgeführt sind. Zur Ansteuerung dient ein so genannter Gate- oder Steueranschluss 6. Ferner ist ein Hilfsemitteranschluss 7a erkennbar, mit welchem dem Steueranschluss 6 das zweckmäßige elektrische Potenzial aufgeprägt werden kann. Ein Hilfskollektoranschluss ist mit 7b referenziert. Selbstverständlich ist es möglich, dass der mit dem Bezugszeichen 4 versehene Lastanschluss den Kollektoranschluss und der mit dem Bezugszeichen 5 versehene Lastanschluss 5 den Emitteranschluss ausbildet.

Innerhalb des Halbleitergehäuse 2 sind Leistungshalbleiterchips beispielsweise IGBT-(Insulated-Gate Bipolar Transistor)-Chips angeordnet, die ebenfalls Stand der Technik und in Figur 2 verdeutlicht sind.

Die Figur 2 zeigt in einer Seitenansicht schematisch einen IGBT-Chip 8 des Leistungshalbleiterschalters 1 gemäß Figur 1, der über eine Lötverbindung 9 mit einer leitenden Kupferschicht 10 verbunden ist, die auf einem nichtleitenden Substrat 11, beispielsweise aus einer zweckmäßigen Keramik, aufgebracht ist. Das Substrat 11 ist mechanisch über eine weitere Lötverbindung 9 mit der Basisplatte 3 verbunden. Zur elektrischen Verbindung mit weiteren Leistungshalbleiterchips 8 dienen Bonddrähte 12, von denen in Figur 2 aus Gründen der Übersichtlichkeit lediglich einer gezeigt ist. Die Bonddrähte 12 sind in dem gezeigten Ausführungsbeispiel mit der Emitterseite des IGBT-Chips 8 als Chiplastanschluss verbunden. Es ist ferner erkennbar, dass die Kupferschicht 10 Leiterbahnen ausbildet, mit denen eine zweckmäßige Verschaltung der IGBT-Chips 8 u. a. mittels der Bonddrähte 12 ermöglicht ist.

Der in Figur 1 gezeigte Leistungshalbleiterschalter 1 weist insgesamt 24 IGBT-Chips gemäß Figur 2 sowie zwölf diesbezüglich gegensinnig parallel geschaltete Diodenchips auf, die alle in dem Gehäuse 2 untergebracht sind. Alternativ hierzu können auch 18 IGBT-Chips und 18 Diodenchips verbaut sein. Als weitere Alternative können 36 rückwärts leitende IGBT-Chips in dem Gehäuse untergebracht sein, wobei eine gegensinnig parallele Diode und der IGBT-Chip in einem Chip integriert sind. Diese Leistungshalbleiterchips sind in drei voneinander weitgehend unabhängig parallel geschalteten Leistungshalbleitersegmenten angeordnet, so dass ein Leistungshalbleitersegment über jeweils acht IGBT-Chips und vier Dioden-Chips verfügt. Die Lastanschlüsse dieser drei Leistungshalbleitersegmente, also drei Emitteranschlüsse 4 sowie drei Kollektoranschlüsse 5 sind einzeln aus dem Halbleitergehäuse 2 herausgeführt und somit einzeln kontaktierbar. Gemäß dem Stand er Technik sind die Lastanschlüsse an der gleichen Gehäuseseite angeordnet. Während des Normalbetriebs teilt sich der gesamte über den Leistungshalbleiterschalter 1 fließende Strom in etwa gleich auf die drei Leistungshalbleitersegmente mit ihrem jeweiligen Emitter- 4 und Kollektoranschluss 5 auf. Mit anderen Worten führt der Zuleiter eines jeden Kollektoranschlusses 5 bzw. der Zuleiter eines jeden Emitteranschlusses 4 in etwa den gleichen Strom.

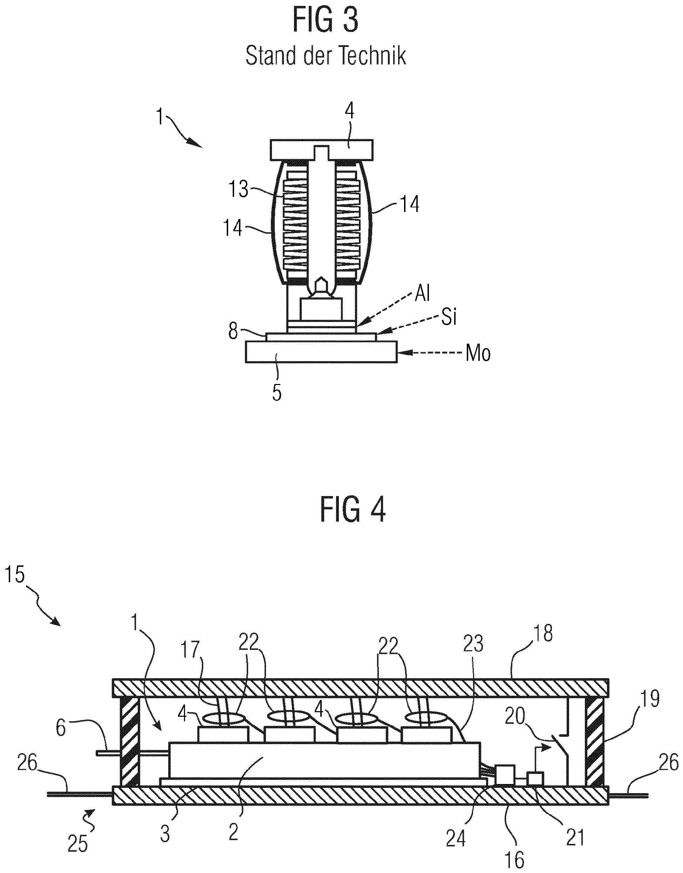

Figur 3 zeigt einen IGBT-Chip 8 eines vorbekannten druckkontaktierten Leistungshalbleiterschalters 1, der die eingangs erwähnte "Conduct on Fail"-Eigenschaft aufweist. Der in Figur 3 gezeigte Leistungshalbleiterschalter 1 ist ebenfalls in Segmente unterteilt, wobei jedes Segment über einen Emitteranschluss 4 sowie über einen Kollektoranschluss 5 verfügt. Im Gegensatz zur Modulbauweise weist ein "Press-pack" gemäß Figur 3 auf der Emitterseite jedoch keine Bonddrähte zur Verbindung der IGBT-Chips 8 auf. An ihrer Emitterseite sind die Leistungshalbleiterchips 8 über ein Federelement 13 mit Druck beaufschlagt, so dass emitterseitig ein Druckkontakt bereit gestellt ist. Kollektorseitig sind die IGBT-Chips beispielsweise gelötet. Die elektrisch leitende Verbindung mit dem Emitteranschluss 4 wird über einen flexiblen Bandleiter 14 bereitgestellt, mit dem das Federelement 13 elektrisch überbrückt ist. Im Fehlerfall wird der Leistungshalbleiterchip 8 leitend, so dass die gewünschte "Conduct on Fail"-Eigenschaft bereitgestellt ist. Bei einer Reihenschaltung von Leistungshalbleiterschaltern 1 gemäß Figur 3 führt der Ausfall eines Leistungshalbleiterschalters 1 nicht dazu, dass die gesamte Reihenschaltung ihren Betrieb nicht mehr fortsetzen kann. Vielmehr übernehmen die mit dem fehlerhaften Leistungshalbleiterschalter 1 in Reihe geschalteten Leistungshalbleiterschalter 1 die Funktion, die der fehlerhafte Leistungshalbleiterschalter bisher ausgefüllt hatte, wobei die Bandleiter 14 des defekten Chips in der Lage sind, den gesamten Laststrom zu führen. Bei turnusmäßig stattfindenden Wartungsarbeiten kann der fehlerhafte Leistungshalbeiterschalter 1 schließlich ausgetauscht werden.

Figur 4 zeigt eine weitere Schaltungseinheit (15) für die erfindungsgemäße Reihenschaltung die einen Leistungshalbleiterschalter 1 gemäß Figur 1 aufweist, wobei der Leistungshalbleiterschalter 1 vier Emitteranschlüsse 4 und vier Kollektoranschlüsse 5 aufweist. Die Kollektoranschlüsse 5 sind in der in Figur 4 gezeigten Seitenansicht von den Emitteranschlüssen 4 verdeckt und somit nicht erkennbar. Der Leistungshalbleiterschalter 1 ist an seiner Basisplatte 3 fest mit einer Kollektorplatte 16 verschraubt, die aus einem metallischen elektrisch leitfähigen Material besteht. Die in Figur 4 verdeckt angeordneten Kollektoranschlüsse 5 des Leistungshalbleiterschalters 1 sind über ebenfalls nicht gezeigte Anschlussleitungen mit der Kollektorplatte 16 leitend verbunden. Die Emitteranschlüsse 4 sind über Anschlussleitungen 17 mit einer Emitterplatte 18 verbunden. Die Emitterplatte 18 ist über eine Seitenwandung 19 als Zwischenbauteil an der Kollektorplatte 16 abgestützt. Die Seitenwandung 19 dient somit als druckaufnehmendes Zwischenbauteil und besteht aus einem elektrisch nicht leitenden Material, beispielsweise einem zweckmäßigen Kunststoff, der eine hohe mechanische Festigkeit aufweist. Die Emitterplatte 18, die Kollektorplatte 16 und die Seitenwand 19 bilden somit ein umfänglich geschlossenes Schaltungsgehäuse aus, so dass ein Schutz vor Verunreinigungen und Explosionen im Fehlerfall bereitgestellt ist.

Zur Überbrückung des Leistungshalbleiterschalters 1 im Fehlerfall dient ein im Schaltungsgehäuse angeordneter Überbrückungsschalter 20, der hier als mechanischer Schalter ausgestaltet ist. Der mechanische Überbrückungsschalter 20 verfügt über eine Vakuumschaltröhre, die mit einem pyrotechnischen Antrieb 21 ausgerüstet ist, der in Figur 4 nur schematisch dargestellt ist. Als Auslösemittel für den pyrotechnischen Antrieb 21 sind Mittel zur Erfassung einer unsymmetrischen Stromverteilung vorgesehen. Diese umfassen in dem in Figur 4 gezeigten Ausführungsbeispiel vier Rogowski-Spulen 22 als Messsensoren, die jeweils einer Anschlussleitung 17 der Emitteranschlüsse 4 zugeordnet sind. Für die in Figur 4 nicht gezeigten Kollektoranschlüsse sind keine Rogowski-Spulen oder sonstige Messwicklungen vorgesehen. Die vier Rogowski-Spulen 22 sind jeweils über Signalleitungen 23 mit einer nur schematisch angedeuteten Verschaltungseinheit 24 verbunden, welche die Signalleitungen 23 so miteinander verschaltet, dass die Messsignale der Rogowski-Spulen 22 miteinander aufaddiert werden. Zwei der vier Rogowski-Spulen weisen hierbei jedoch bezüglich der verbleibenden zwei Rogowski-Spulen eine entgegengesetzte Wicklungsrichtung auf, so dass zwei Messsignale mit jeweils inversem Vorzeichen erzeugt werden. Die vier Messsignale der Rogowski-Spulen 22 addieren sich daher bei einer symmetrischen Verteilung des Stromes auf die vier Emitteranschlüsse 4 zu null. Im Fehlerfall kommt es jedoch zu einer Konzentration des Stromflusses über den Leistungshalbleiterschalter 1 auf den fehlerhaften Leistungshalbleiterchip. Dies führt zu einer unsymmetrischen Verteilung des Stromflusses auf die vier Kollektoranschlüsse 4. Die Verschaltungseinheit 24 erzeugt daher ein Auslösesignal, das zur direkten Zündung des pyrotechnischen Antriebs 21 dient, wodurch der Überbrückungsschalter 20 geschlossen wird. Im Fehlerfall werden die Emitterplatte 18 und die Kollektorplatte 16 somit kurzgeschlossen, so dass eine "Conduct-On-Fail-Eigenschaft" bereitgestellt ist. Die Rogowski-Spulen 22, die Signalleitungen 23 und die Verschaltung 24 bilden somit Auslösemittel aus, die gemeinsam mit dem Überbrückungsschalter 20 einschließlich Antrieb 21 hier beispielhaft als Kurschlussmittel bezeichnet werden.

Es ist erkennbar, dass sämtliche Bauteile, also sowohl die Kurzschlussmittel 22, 23, 24, 21 und 20 als auch der gesamte Leistungshalbleiterschalter 1 innerhalb des umfänglich geschlossenen Schaltungsgehäuses 25 angeordnet sind.

Um für die in dem Schaltungsgehäuse 2 angeordneten Leistungshalbleiterchips, also sowohl für die IGBT-Chips als auch für die antiparallel dazu geschalteten Dioden-Chips, eine ausreichende Kühlung bereitzustellen, ist die Kollektorplatte 16 als Kühlplatte ausgestaltet. In Figur 4 sind daher Kühlleitungen 26 vorgesehen, welche in rohrförmigen Ausnehmungen der Kollektorplatte 16 münden und aus einem elektrisch nicht leitenden Material bestehen. Das in den Kühlleitungen 26 umgewälzte Kühlwasser, beispielsweise deionisiertes Wasser, durchfließt somit die Kollektorplatte 16, so dass es zu einem Abtransport der während des Betriebs der IGBT-Chips erzeugten Wärme kommt.

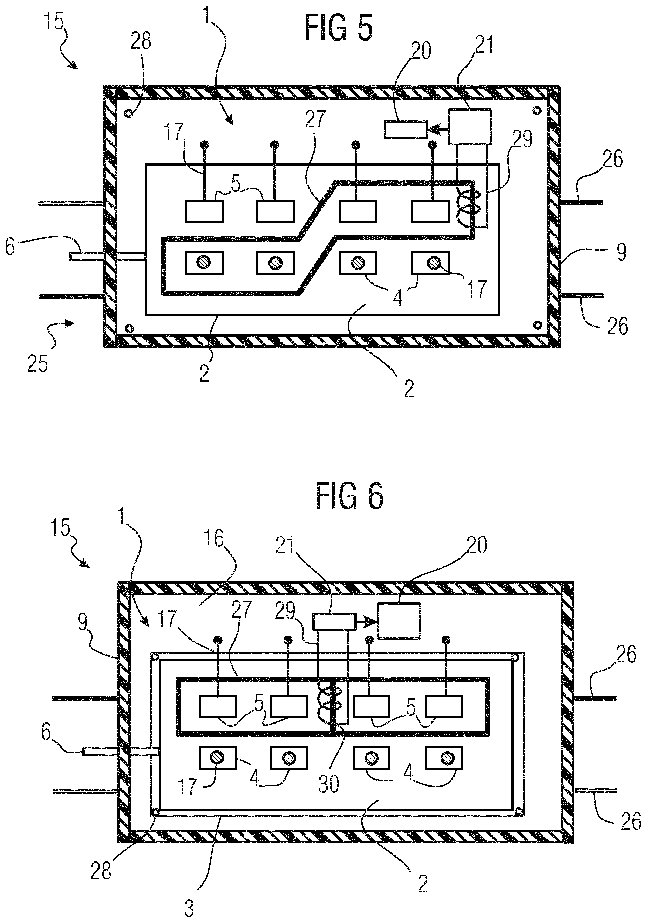

Figur 5 zeigt eine weitere Schaltungseinheit (15) für die erfindungsgemäße Reihenschaltung in einer Draufsicht. Im Gegensatz zu dem in Figur 4 gezeigten Ausführungsbeispiel ist die Fläche der Basisplatte 3 wesentlich größer ausgestaltet. Sie entspricht hier der Fläche der in Figur 5 nicht sichtbaren Kollektorplatte 16. Die Basisplatte 3 ist nicht nur durch Schraubverbindungen 28 mit der Kollektorplatte 16 verbunden. Vielmehr ist die Seitenwand 19 auf der Basisplatte 3 abgestützt, so dass es bei einem Verspannen von Emitterplatte 18 und Kollektorplatte 16 zu einem verbesserten Kontakt zwischen Basisplatte 3 und Kollektorplatte 16 kommt. Darüber hinaus unterscheidet sich das in Figur 5 dargestellte Ausführungsbeispiel von dem in Figur 4 gezeigten Ausführungsbeispiel in der Ausgestaltung der Mittel zur Erfassung einer unsymmetrischen Stromverteilung auf die Lastanschlüsse 4 beziehungsweise 5. So umfassen die besagten Mittel zur Erfassung einer unsymmetrischen Stromverteilung in Figur 5 ein weichmagnetisches Joch 27, welches zwei Emitteranschlüsse 4 und zwei Kollektoranschlüsse 5 mit seinen Schenkeln umschließt. An einem Schenkel des weichmagnetischen Jochs 27 ist eine Messspule 29 vorgesehen, die wiederum mit dem Antrieb 21 verbunden ist, der zum Schließen eines Überbrückungsschalters 20 eingerichtet ist.

Bei Normalbetrieb des Leistungshalbleiterschalters 1 zwischen den voneinander isolierten Kollektor- und Emitterplatten 16, 18 kommt es zu einer symmetrischen Stromverteilung auf die Lastanschlüsse 4,5, wodurch sich die von den Strömen erzeugten Magnetfelder in einem weichmagnetischen Joch 27 gegenseitig auslöschen. Das Ausgangssignal der Messspule 29 ist daher im Wesentlichen gleich null. Im Fehlerfall stellt sich jedoch eine asymmetrische oder unsymmetrische Stromverteilung ein, so dass in dem von der Messspule 29 erfassten Schenkel des Jochs 27 ein messbares Magnetfeld einstellt, wodurch die Messspule 29 ein Auslösesignal erzeugt, das direkt zum Zünden des pyrotechnischen Antriebs 21 des Schalters 20 eingesetzt wird. Es kommt zu dem gewünschten Überbrücken des Leistungshalbleiterschalters 1 und somit zu einer "Conduct-On-Fail-Eigenschaft" des so genannten "Pseudo Pressback".

Figur 6 zeigt eine weitere Schaltungseinheit (15) für die erfindungsgemäße Reihenschaltung. Auch hier umfassen die Mittel zur Erfassung einer unsymmetrischen Stromverteilung auf die Lastanschlüsse 4 oder 5 ein weichmagnetisches Joch 27, das in dem gezeigten Ausführungsbeispiel jedoch lediglich die Kollektoranschlüsse 5 umfasst, wobei die Kollektoranschlüsse 5 in zwei Hälften unterteilt werden, die jeweils von Schenkeln des weichmagnetischen Jochs 27 umgeben sind. Dabei umfasst das weichmagnetische Joch 27 einen Verbindungssteg 30, der von einer Messspule 29 umgeben ist. Der Ausgang der Messspule 29 ist wieder mit einer Antriebseinheit 21, in diesem Fall einer pyrotechnischen Antriebseinheit für einen mechanischen Schalter 20, verbunden. Selbstverständlich kann es sich bei dem Schalter 20 auch um einen elektronischen Schalter beispielsweise in Gestalt eines Thyristors handeln, wobei das Auslösesignal der Messspule 29 direkt zur elektrischen Zündung des Thyristors im Fehlerfall verwendet wird. Kommt es zu einer unsymmetrischen Stromverteilung in den Kollektoranschlüssen 5, entsteht in dem Verbindungssteg 30 ein nachweisbares magnetisches Feld. Bei einer symmetrischen Verteilung der Stromflüsse auf die Kollektoranschlüsse 5 ist das Magnetfeld in dem Verbindungssteg 30 jedoch etwa gleich null, so dass es zu keiner Auslösung des Schalters 20 kommt.

Darüber hinaus ist die Basisplatte 3 des Leistungshalbleiterschalters 1 hinsichtlich ihrer Auflagefläche nicht genau so groß wie die Kollektorplatte 16 dimensioniert. Aus diesem Grunde ist das Schaltungsgehäuse 25 nicht auf der Basisplatte 3 abgestützt. Es kann jedoch ausreichend sein, wenn die Basisplatte 3 fest genug auf der Kollektorplatte 16 aufgeschraubt ist, um einen ausreichend hohen Druckkontakt bereitzustellen.

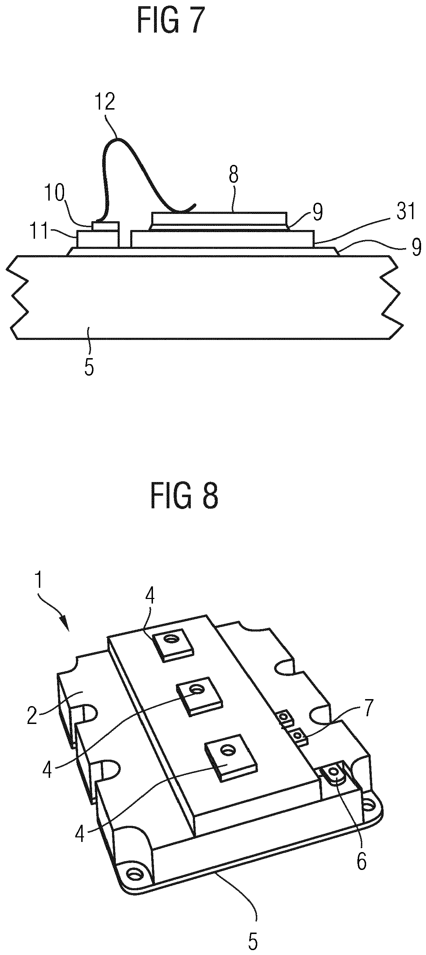

Figur 7 zeigt die Anbindung eines IGBT-Chips 8 bei einem erfindungsgemäß abgewandelten Leistungshalbleiterschalter. Auch hier sind die IGBT-Chips 8 an ihrer Emitterseite miteinander verbunden, wobei die emitterseitige Verbindung über Bonddrähte 12 und Kupferleiterbahnen 10 erfolgt, die auf einem elektrisch isolierenden Keramiksubstrat 11 aufgebracht sind. Im Gegensatz zu dem in Figur 2 gezeigten Beispiel des Standes der Technik ist hier jedoch jeder IGBT-Chip 8 an seiner Kollektorseite über eine Lötverbindung 9 direkt mit einer metallischen elektrisch leitenden Zwischenschicht 31 sowohl mechanisch als auch elektrisch verbunden, die wiederum über eine Lötverbindung 9 mit der metallisch leitenden Basisplatte 3 verbunden ist, so dass die Basisplatte 3 gemäß diesem Ausführungsbeispiel der Erfindung als allen IGBT-Chips 8 gemeinsamer Kollektoranschluss dient. Emitterseitig sind die IGBT-Chips in zueinander parallel geschalteten Segmenten verschaltet, wobei jedes Segment einen Emitteranschluss 4 ausbildet, der an einer vom Kollektoranschluss 5 abgewandten Seite des in Figur 4 nicht gezeigten Halbleitergehäuses 2 angeordnet ist.

Figur 8 zeigt einen Leistungshalbleiterschalter 1 mit einer Chipanbindung gemäß Figur 7. Es ist erkennbar, dass lediglich die Emitteranschlüsse 4 nach oben aus dem Halbleitergehäuse 2 herausgeführt sind. Der Kollektoranschluss 5 fällt mit der Basisplatte 3 zusammen. Somit kann der Leistungshalbleiterschalter 1 direkt auf die Kollektorplatte 16 aufgeschraubt, ohne dass eine weitere Verbindung zwischen Kollektoranschluss 5 und Kollektorplatte 16 nötig wäre. Hierdurch vereinfacht sich die Konstruktion der Schaltungseinheit 15.

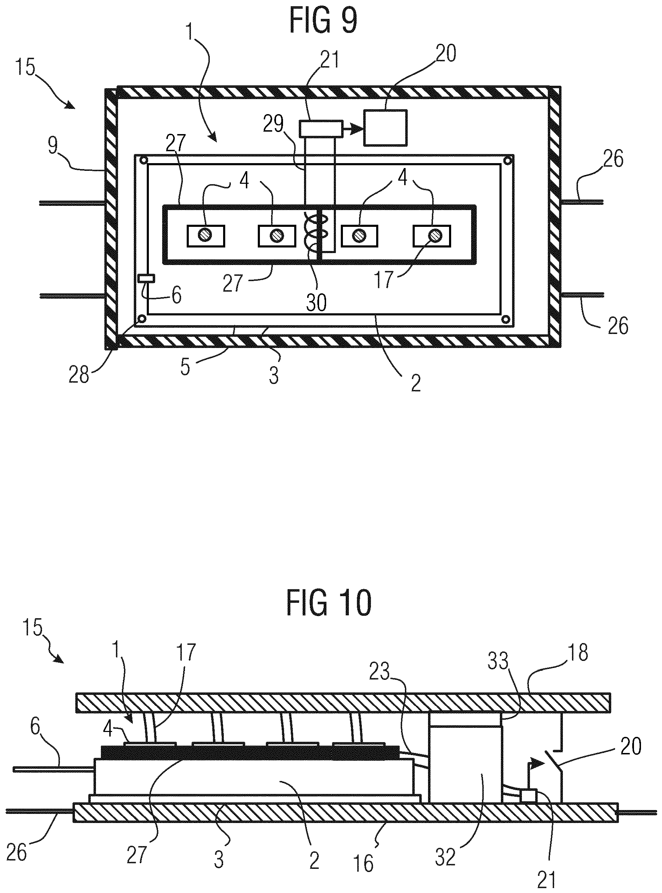

Figur 9 zeigt eine weitere Schaltungseinheit (15) für die erfindungsgemäße Reihenschaltung, die sich von dem in Figur 6 gezeigten Ausführungsbeispiel dadurch unterscheidet, dass die Anbindung der IGBT-chips 8 sowie der Diodenchips gemäß Figur 7 erfolgt, so dass der Emitteranschluss 4 nach oben aus dem Gehäuse herausgeführt und der Kollektoranschluss 5 mit der Basisplatte 3 zusammenfällt, die als gemeinsamer Kollektoranschluss 5 bezeichnet werden kann. Die Basisplatte 5 ist wieder mit der Kollektorplatte 16 durch eine zweckmäßige Verschraubung 28 verbunden.

Figur 10 zeigt eine weitere Schaltungseinheit (15) für die erfindungsgemäße Reihenschaltung die sich von dem Ausführungsbeispiel gemäß Figur 9 dadurch unterscheidet, dass anstelle einer Seitenwandung 19 eine Scheibenzellendiode 32 als Druck aufnehmendes Zwischenbauteil zwischen der Emitterplatte 18 und der Kollektorplatte 16 angeordnet ist. Dabei ist die Scheibenzellendiode 32 zweckmäßigerweise mit einer Deformationsschicht 33 aus Kupfer versehen. Die Deformationsschicht 33 ist elektrisch leitend und deformierbar, so dass bei einem Verspannen von Kollektor- und Emitterplatte 16, 18 eine Zerstörung der Scheibenzellendioden 32 vermieden ist. Die Zerstörung oder Beschädigung der Scheibenzellendiode 32 auf Grund mechanischer Kräfte kann grundsätzlich durch beliebige Mittel verhindert werden. So kann beispielsweise die Emitterplatte 18 aus einem elastischen Material bestehen, das jedoch leitfähig ist. Die Scheibenzellendiode 32 kann im Fall einer abgedichteten Variante ohne eigenes Keramikgehäuse ausgeführt sein. Der Leistungshalbleiterschalter 1 weist in seinem Halbleitergehäuse 2 lediglich IGBT-Chips auf. Dabei ist die Basisplatte 3 zweckmäßig mit der Kollektorplatte 16 verbunden und beispielsweise verschraubt. Auf der Kollektorplatte 16 ist auch eine Seite der Scheibenzellendiode 32 kontaktiert. Die andere Seite der Scheibenzellendiode ist mit der Emitterplatte 18 elektrisch leitend verbunden. Die Verbindung der Emitteranschlüsse 4 des Leistungshalbleiterschalters 1 mit der Emitterplatte 18 erfolgt über geeignete Anschlussleitungen, so dass die Lastanschlüsse 4,5 des Leistungshalbleiterschalters spannungsfrei zwischen Emitterplatte 18 und Kollektorplatte 16 gehalten sind. Die Bauhöhe der Schaltungseinheit ist also durch die Dicke der Scheibenzellendiode bestimmt. Der Leistungshalbleiterschalter 1 kann isoliert auf der Basisplatte 2 gehaltene IGBT-Chips 8 gemäß Figur 2 oder Halbleiterchips aufweisen, die kollektorseitig leitend mit der Basisplatte 3 (Figur 7) verbunden sind. Im Fall eines isolierten Aufbaus gemäß Figur 2 sind die Kollektoranschlüsse 5 des Leistungshalbleiterschalters 1 natürlich mittels zweckmäßiger Verbindungsleitungen leitend mit der Kollektorplatte 16 verbunden. Die nach oben aus dem Halbleitergehäuse 2 herausgeführten Emitteranschlüsse 4 sind wieder paarweise von Schenkeln des weichmagnetischen Jochs 27 umgeben, so dass in dem in Figur 10 nicht sichtbaren Verbindungssteg erst bei einer unsymmetrischen Verteilung des Stromflusses auf die Emitteranschlüsse 4 ein magnetisches Feld entsteht, dass zu einem Auslösesignal der Messspule 29 führt, mit dem der pyrotechnische Antrieb 27 des Schalters 20 gezündet wird.

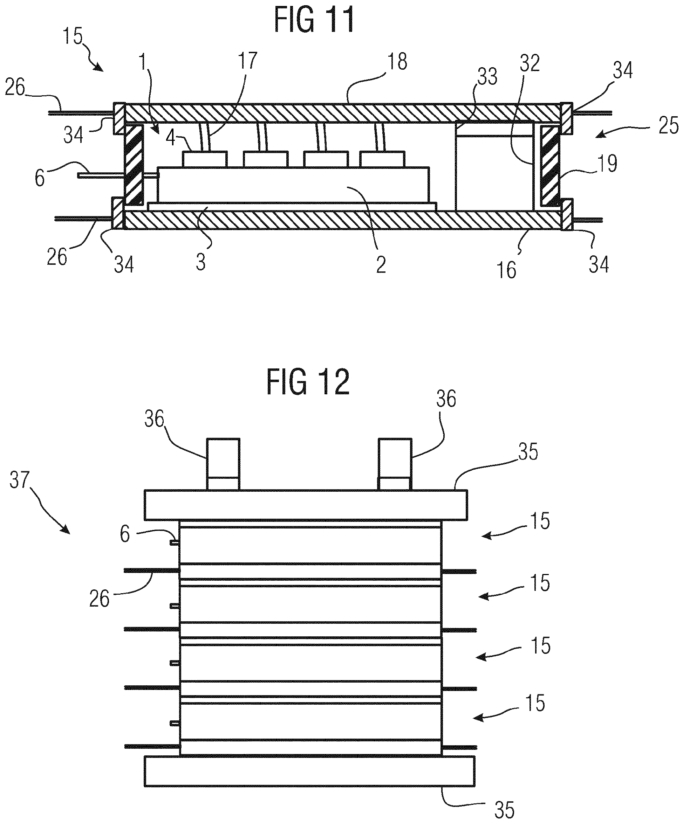

Figur 11 zeigt eine weitere Schaltungseinheit (15) für die erfindungsgemäße Reihenschaltung mit einer Scheibenzellendiode 32, die mit ihrer Deformationssicht 33 zwischen der Emitterplatte 18 und der Kollektorplatte 16 druckaufnehmend angeordnet ist. Darüber hinaus ist auch eine Seitenwandung 2 bereitgestellt, deren Höhe oder Dicke hier etwas geringer ist als die Höhe oder Dicke der Scheibenzellendiode 32 einschließlich Deformationsschicht 33, so dass die Kollektorplatte 16 und die Emitterplatte 18 auch weiterhin ausschließlich über die Scheibenzellendiode 32, 33 aneinander abgestützt ist. Bei einer elastischen Emitterplatte 18 kann die Seitenwandung 19 auch genauso hoch sein, wie die Scheibenzellendiode 32 einschließlich ihrer Deformationsschicht 33. Bei miteinander verspannten Schaltungseinheiten 15 ist es dann jedoch wesentlich, dass die Spannmittel im Bereich der Scheibenzellendiode 32 angeordnet sind, so dass die Spannkraft im Wesentlichen in die Scheibenzellendiode 32 eingeleitet wird. Die Seitenwandung 19 erstreckt sich umfänglich um den Leistungshalbleiterschalter 1 und dient zum Schutz vor Verunreinigungen und wirkt darüber hinaus auch als Explosionsschutz. Die Seitenwand 19 wird sowohl an der Kollektorplatte 16 als auch an der Emitterplatte 18 über Halteschultern 34 formschlüssig und somit spannungsfrei gehalten. In dem in Figur 11 gezeigten Ausführungsbeispiel sind jedoch keine Kurzschlusseinrichtungen vorhanden. Die dort gezeigte Schaltungseinheit weist daher eine "Conduct-On-Fail-Eigenschaft" in nur einer Richtung auf, nämlich in der Durchlassrichtung der Scheibenzellendioden, welche der Durchlassrichtung der IGBT-Chips 8 in dem Leistungshalbleiterschalter 1 gegensinnig parallel geschaltet ist. Der Leistungshalbleiterschalter 1 weist keine eigenen Diodenchips auf. Darüber hinaus sind die IGBT-Chips 8 leitend mit der Basisplatte 3 verbunden. Selbstverständlich ist auch bei diesem Ausführungsbeispiel ein isolierter Aufbau gemäß Figur 2 möglich.

Figur 12 zeigt erfindungsgemäße Reihenschaltung 37 von Schaltungseinheiten 15 gemäß der Figuren 5, 6, 8, 9, 10 oder 11. Es ist erkennbar, dass die Schaltungseinheiten 15 aufeinander gestapelt sind, wobei die Kollektor- und Emitterplatten 16, 18 benachbarter Schaltungseinheiten 15 miteinander druckkontaktiert sind. Um für einen ausreichend guten Kontakt zu sorgen, sind die Schaltungseinheiten 15 miteinander verspannt. Hierzu dienen zwei Spannplatten 35, die über zweckmäßige Zugmittel 36 miteinander verbunden sind.

## Patentansprüche

1. Reihenschaltung (37) mit mehreren in Reihe geschalteten Schaltungseinheiten, wobei die Schaltungseinheiten (15) aufeinander gestapelt und mittels Spannmitteln (35, 36) miteinander verspannt sind, und die Schaltungseinheiten (15) für einen Umrichter jeweils einen in der Industrie üblichen, kostengünstigen Leistungshalbleiterschalter (1) in Modulbauform aufweisen, der wenigstens einen Kollektoranschluss (5), wenigstens einen Emitteranschluss (4) als Lastanschlüsse und einen Steueranschluss (6) aufweist, wobei in einem Halbleitergehäuse (2) angeordnete Leistungshalbleiterchips (8) über Bonddrähte (12), die zum Führen von Laststrom ausgelegt sind, miteinander verbunden sind und einen über den Steueranschluss (6) steuerbaren Strompfad zwischen den Lastanschlüssen (4,5) bereitstellen, wobei der Leistungshalbleiterschalter (1) von seiner Durchlassstellung, in der ein Stromfluss zwischen den Lastanschlüssen (4,5) in einer Durchlassrichtung ermöglicht ist, in seine Sperrstellung oder umgekehrt überführt wird, in der ein Stromfluss zwischen den Lastanschlüssen (4,5) unterbrochen ist, wobei
der Leistungshalbleiterschalter (1) zwischen einer elektrisch mit den Emitteranschlüssen (4) verbundenen Emitterplatte (18) und einer elektrisch mit den Kollektoranschlüssen (5) verbundenen Kollektorplatte (16) angeordnet ist, wobei die Emitterplatte (18) und die Kollektorplatte (16) elektrisch leitend sind und über ein Zwischenbauteil (19,32) aneinander abgestützt sind, das einen Stromfluss zwischen Emitterplatte (18) und Kollektorplatte (16) in wenigstens einer Richtung verhindert, die Emitterplatte (18) und die Kollektorplatte (16) Bestandteile der Schaltungseinheit sind und voneinander abgewandte Seiten von deren Schaltungsgehäuse bilden und das Halbleitergehäuse (2) zwischen der Emitterplatte (18) und der Kollektorplatte (16) angeordnet ist, so dass ein "Pseudo-Press-Pack" bereitgestellt wird,
und dass die Kollektor- und Emitterplatten (16, 18) benachbarter Schaltungseinheiten (15) miteinander druckkontaktiert sind.

2. Reihenschaltung (37) nach Anspruch 1,
**dadurch gekennzeichnet, dass**
das Zwischenbauteil als elektrisch isolierende umfängliche geschlossene Seitenwand (19) ausgestaltet ist, so dass Emitterplatte (18), Kollektorplatte (16) und Seitenwand (19) ein geschlossenes Schaltungsgehäuse (25) ausbilden.

3. Reihenschaltung (37) nach Anspruch 1,
**dadurch gekennzeichnet, dass**
das Zwischenbauteil als wenigstens eine Scheibenzellendiode (32) ausgestaltet ist, die gegensinnig parallel zur Durchlassrichtung des Leistungshalbleiterschalters (1) geschaltet ist.

4. Reihenschaltung (37) nach Anspruch 3,
**dadurch gekennzeichnet, dass**
eine elektrisch isolierende und umfänglich geschlossene Seitenwand (19) vorgesehen ist, deren Höhe kleiner ist als die Höhe der Scheibenzellendiode (32,33), wobei Emitterplatte (18), Kollektorplatte (16) und Seitenwand (19) ein Schaltungsgehäuse (25) ausbilden.

5. Reihenschaltung (37) nach Anspruch 4,
**dadurch gekennzeichnet, dass**
die Seitenwand (19) formschlüssig von der Emitterplatte (18) und/oder der Kollektorplatte (16) gehalten ist.

6. Reihenschaltung (37) nach einem der vorhergehenden Ansprüche,
**dadurch gekennzeichnet, dass**
das Halbleitergehäuse (2) eine elektrisch leitende Basisplatte (3) aufweist, wobei jeder Leistungshalbleiterchip (8) zwei Chiplastanschlüsse aufweist und mit einem seiner Chiplastanschlüsse elektrisch leitend mit der Basisplatte (3) verbunden ist, so dass die Basisplatte (3) einen der Lastanschlüsse (5) des Leistungshalbleiterschalters (1) ausbildet.

7. Reihenschaltung (37) nach Anspruch 6,
**dadurch gekennzeichnet, dass**
jeder Leistungshalbleiterchip (8) flächig mit der Basisplatte (3) oder mit einer elektrisch leitenden Zwischenschicht (31) verbunden ist, die im elektrischen Kontakt mit der Basisplatte (3) steht.

8. Reihenschaltung (37) nach einem der vorhergehenden Ansprüche,
**dadurch gekennzeichnet, dass**
die Kollektorplatte (16) und/oder die Emitterplatte (18) mit Kühlmitteln (26) zum Kühlen der Leistungshalbleiterchips (8) ausgerüstet ist/sind.

9. Reihenschaltung (37) nach einem der vorhergehenden Ansprüche,
**gekennzeichnet durch**
Kurschlussmittel (22,23,24,21,20,27,29,30), die zum Kurzschließen der Emitterplatte (18) und der Kollektorplatte (16) im Fehlerfall eingerichtet sind.

10. Reihenschaltung (37) nach Anspruch 9,
**dadurch gekennzeichnet, dass**
der Leistungshalbleiterschalter (1) mit wenigstens zwei parallel zueinander geschalteten Leistungshalbleitersegmenten ausgerüstet ist, die jeweils zwei Lastanschlüsse in Gestalt des Kollektor- (5) und Emitteranschlusses (4) aufweisen, wobei die Kurzschlussmittel Mittel (22,23,24,27,29,30) zur Erfassung einer unsymmetrischen Verteilung des Stromes auf die Lastanschlüsse (4,5) des Leistungshalbleiterschalters (1) aufweisen.

11. Reihenschaltung (37) nach Anspruch 10,
**dadurch gekennzeichnet, dass**
die Mittel zur Erfassung einer unsymmetrischen Stromverteilung eine Messeinheit mit wenigstens einem Messsensor (22,29) aufweisen, die zur Erfassung eines Stromflusses über wenigstens zwei Lastanschlüsse (4,5) oder zur Erfassung einer aus dem besagten Stromfluss abgeleiteten Größe eingerichtet ist.

12. Reihenschaltung (37) nach Anspruch 11,
**dadurch gekennzeichnet, dass**
jeder Messsensor (22,29) zum Erfassen des Stromflusses an einem zugeordneten Lastanschluss (4,5) eingerichtet ist.

13. Reihenschaltung (37) nach einem der Ansprüche 10 oder 11, **dadurch gekennzeichnet, dass**
die Mittel (22,23,24,27,29,30) zur Erfassung einer unsymmetrischen Stromverteilung ein weichmagnetisches Joch (27,30) und wenigstens ein Messsensor (29) aufweisen, der zum Erfassen eines magnetischen Feldes in dem weichmagnetischen Joch (27,30) eingerichtet ist.

14. Reihenschaltung (37) nach einem der Ansprüche 9 bis 13,
**dadurch gekennzeichnet, dass**
die Kurzschlussmittel einen Überbrückungsschalter (20) aufweisen.

15. Reihenschaltung (37) nach einem der Ansprüche 9 bis 14,
**dadurch gekennzeichnet, dass** die Kurschlussmittel zumindest teilweise zwischen der Emitterplatte (18) und der Kollektorplatte (16) sind.

16. Reihenschaltung (37) nach Anspruch 15,
**dadurch gekennzeichnet, dass** Emitterplatte (18) und Kollektorplatte (16) ein Schaltungsgehäuse (25) ausbilden, wobei die Kurzschlussmittel zumindest teilweise in dem Schaltungsgehäuse (25) angeordnet sind.

## Claims

1. Series circuit (37) having a plurality of circuit units connected in series, wherein the circuit units (15) are stacked on one another and braced with respect to one another by means of clamping means (35, 36), and the circuit units (15) each have an industrially conventional, cost-effective power semiconductor switch (1) in modular form for a converter, which power semiconductor switch has at least one collector terminal (5), at least one emitter terminal (4) as load terminals and a control terminal (6), wherein power semiconductor chips (8) arranged in a semiconductor housing (2) are connected to one another by means of bonding wires (12), which are designed to conduct a load current, and provide a current path between the load terminals (4, 5), which current path can be controlled by means of the control terminal (6), wherein the power semiconductor switch (1) is transferred from its conducting position, in which a flow of current between the load terminals (4, 5) in a forward direction is made possible, to its blocking position or vice versa, in which blocking position a flow of current between the load terminals (4, 5) is interrupted, wherein the power semiconductor switch (1) is arranged between an emitter plate (18) electrically connected to the emitter terminals (4) and a collector plate (16) electrically connected to the collector terminals (5), wherein the emitter plate (18) and the collector plate (16) are electrically conductive and are supported against one another by means of an intermediate component (19, 32), which prevents a flow of current between the emitter plate (18) and the collector plate (16) in at least one direction, the emitter plate (18) and the collector plate (16) are constituent parts of the circuit unit and form sides of the circuit housing thereof that face away from one another and the semiconductor housing (2) is arranged between the emitter plate (18) and the collector plate (16) so that a "pseudo-press-pack" is produced, and in that the collector and emitter plates (16, 18) of adjacent circuit units (15) make pressure-contact with one another.

2. Series circuit (37) according to Claim 1, **characterized in that** the intermediate component is designed as an electrically insulating, circumferentially closed side wall (19) so that the emitter plate (18), the collector plate (16) and the side wall (19) form a closed circuit housing (25).

3. Series circuit (37) according to Claim 1, **characterized in that** the intermediate component is designed as at least one disc-cell diode (32), which is connected in the opposite direction in parallel with the forward direction of the power semiconductor switch (1).

4. Series circuit (37) according to Claim 3, **characterized in that** an electrically insulating and circumferentially closed side wall (19) is provided, the height of which is lower than the height of the disc-cell diode (32, 33), wherein the emitter plate (18), the collector plate (16) and the side wall (19) form a circuit housing (25).

5. Series circuit (37) according to Claim 4, **characterized in that** the side wall (19) is held in a form-fitting manner by the emitter plate (18) and/or the collector plate (16).

6. Series circuit (37) according to one of the preceding claims, **characterized in that** the semiconductor housing (2) has an electrically conductive base plate (3), wherein each power semiconductor chip (8) has two chip load terminals and is electrically conductively connected by way of one of the chip load terminals thereof to the base plate (3) so that the base plate (3) forms one of the load terminals (5) of the power semiconductor switch (1).

7. Series circuit (37) according to Claim 6, **characterized in that** each power semiconductor chip (8) is connected areally to the base plate (3) or to an electrically conductive intermediate layer (31), which is in electrical contact with the base plate (3).

8. Series circuit (37) according to one of the preceding claims, **characterized in that** the collector plate (16) and/or the emitter plate (18) is/are provided with cooling means (26) to cool the power semiconductor chips (8).

9. Series circuit (37) according to one of the preceding claims, **characterized by** short-circuiting means (22, 23, 24, 21, 20, 27, 29, 30), which are configured to short-circuit the emitter plate (18) and the collector plate (16) in the event of a fault.

10. Series circuit (37) according to Claim 9, **characterized in that** the power semiconductor switch (1) is provided with at least two power semiconductor segments, which are connected in parallel with one another and which each have two load terminals in the form of the collector terminal (5) and emitter terminal (4), wherein the short-circuiting means have means (22, 23, 24, 27, 29, 30) for detecting an asymmetrical distribution of the current over the load terminals (4, 5) of the power semiconductor switch (1).

11. Series circuit (37) according to Claim 10, **characterized in that** the means for detecting an asymmetrical current distribution have a measurement unit having at least one measurement sensor (22, 29), which measurement unit is configured to detect a flow of current via at least two load terminals (4, 5) or to detect a variable derived from said flow of current.

12. Series circuit (37) according to Claim 11, **characterized in that** each measurement sensor (22, 29) is configured to detect the flow of current at an associated load terminal (4, 5) .

13. Series circuit (37) according to either of Claims 10 and 11, **characterized in that** the means (22, 23, 24, 27, 29, 30) for detecting an asymmetrical current distribution have a soft-magnetic yoke (27, 30) and at least one measurement sensor (29), which is configured to detect a magnetic field in the soft-magnetic yoke (27, 30).

14. Series circuit (37) according to one of Claims 9 to 13, **characterized in that** the short-circuiting means have a bypass switch (20).

15. Series circuit (37) according to one of Claims 9 to 14, **characterized in that** the short-circuiting means are at least partly arranged between the emitter plate (18) and the collector plate (16).

16. Series circuit (37) according to Claim 15, **characterized in that** the emitter plate (18) and the collector plate (16) form a circuit housing (25), wherein the short-circuiting means are at least partly arranged in the circuit housing (25).

## Revendications

1. Circuit (37) série, comprenant plusieurs unités de circuit montées en série, les unités (15) de circuit étant empilées les unes sur les autres et serrées entre elles au moyen de moyens (35, 36) de serrage et les unités (15) de circuit ayant, sous une forme de construction modulaire pour un onduleur, chacune un interrupteur (1) à semi-conducteur de puissance, qui est habituel dans l'industrie, qui est peu coûteux et qui a au moins une borne (5) de collecteur, au moins une borne (4) d'émetteur, comme bornes de charge et une borne (6) de commande, dans lequel des puces (8) à semi-conducteur de puissance, montées dans un boîtier (2) à semi-conducteur, sont reliées entre elles par des fils (12) de liaison conçus pour faire passer du courant de charge et procurent, entre les bornes (4, 5) de charge, un trajet de courant pouvant être réglé par la borne (6) de commande, dans lequel l'interrupteur (1) à semi-conducteur de puissance passe de sa position à l'état passant, dans laquelle un flux de courant, entre les bornes (4, 5) de charge, est possible dans un sens de passage, à sa position de blocage, ou inversement, dans laquelle un flux de courant des bornes (4, 5) de charge est interrompu, dans lequel
l'interrupteur (1) à semi-conducteur de puissance est monté entre une plaque (18) d'émetteur, reliée électriquement aux bornes (4) d'émetteur, et une plaque (16) de collecteur, reliée électriquement aux bornes (5) de collecteur, la plaque (18) d'émetteur et la plaque (16) de collecteur étant conductrices de l'électricité et étant appuyées l'une contre l'autre par une pièce (19, 32) intermédiaire, qui empêche un flux de courant entre la plaque (18) d'émetteur et la plaque (16) de collecteur dans au moins un sens, la plaque (18) d'émetteur et la plaque (16) de collecteur font partie de l'unité de circuit et forment des faces, loin l'une de l'autre, de leur boîtier de circuit et le boîtier (2) à semi-conducteur est disposé entre la plaque (18) d'émetteur et la plaque (16) de collecteur, de manière à donner un "Pseudo-Press-Pack",
et en ce que les plaques (16, 18) de collecteur et d'émetteur d'unités (15) de circuit voisines sont contactées par pression entre elles.

2. Circuit (37) série suivant la revendication 1,
**caractérisé en ce que**
la pièce intermédiaire est conformée en paroi (19) latérale isolante électriquement et fermée tout autour, de manière à ce que la plaque (18) d'émetteur, la plaque (16) de collecteur et la paroi (19) latérale forment un boîtier (25) de circuit fermé.

3. Circuit (37) série suivant la revendication 1,
**caractérisé en ce que**
la pièce intermédiaire est conformée comme au moins une diode (32) à cellule à disque, qui est montée en parallèle en sens contraire au sens passant de l'interrupteur (1) à semi-conducteur de puissance.

4. Circuit (37) série suivant la revendication 3,
**caractérisé en ce qu'**
il est prévu une paroi (19) latérale, qui est isolante électriquement, qui est fermée sur tout le tour et dont la hauteur est plus petite que la hauteur de la diode (32, 33) à cellule à disque, la plaque (18) d'émetteur, la plaque (16) de collecteur et la paroi (19) latérale formant un boîtier (25) de circuit.

5. Circuit (37) série suivant la revendication 4,
**caractérisé en ce que**
la paroi (19) latérale est maintenue à complémentarité de forme par la plaque (18) d'émetteur et/ou par la plaque (16) de collecteur.

6. Circuit (37) série suivant l'une des revendications précédentes,
**caractérisé en ce que**
le boîtier (2) à semi-conducteur a une plaque (3) de base conductrice de l'électricité, chaque puce (8) à semi-conducteur de puissance ayant deux bornes de charge et étant reliée, par l'une de ses bornes de charge, d'une manière conductrice de l'électricité, à la plaque (3) de base, de sorte que la plaque (3) de base forme l'une des bornes (5) de charge de l'interrupteur (5) à semi-conducteur de puissance.

7. Circuit (37) série suivant la revendication 6,
**caractérisé en ce que**
chaque puce (8) à semi-conducteur de puissance est reliée par une surface à la plaque (3) de base ou a une couche (31) intermédiaire conductrice de l'électricité, qui est en contact électrique avec la plaque (3) de base.

8. Circuit (37) série suivant l'une des revendications précédentes,
**caractérisé en ce que**
la plaque (16) de collecteur et/ou la plaque (18) d'émetteur est/sont équipés de moyens (26) de refroidissement pour refroidir les puces (8) à semi-conducteur de puissance.

9. Circuit (37) série suivant l'une des revendications précédentes,
**caractérisé par**
des moyens (22, 23, 24, 21, 20, 27, 29, 30) de court-circuit, conçus pour court-circuiter la plaque (18) d'émetteur et la plaque (16) de collecteur en cas de défaut.

10. Circuit (37) série suivant la revendication 9,
**caractérisé en ce que**
l'interrupteur (1) à semi-conducteur de puissance est équipé d'au moins deux segments à semi-conducteur de puissance montés en parallèle l'un à l'autre, qui ont chacun deux bornes de charge à la conformation de la borne (5) du collecteur et de la borne (4) de l'émetteur, les moyens de court-circuit ayant des moyens (22, 23, 24, 27, 29, 30) de détection d'une répartition dissymétrique du courant sur les bornes (4, 5) de charge de l'interrupteur (1) à semi-conducteur de puissance.

11. Circuit (37) série suivant la revendication 10,
**caractérisé en ce que**
les moyens de détection d'une répartition dissymétrique du courant comportent une unité de mesure ayant au moins un capteur (22, 29) de mesure, qui est conçu pour détecter un flux de courant sur au moins deux bornes (4, 5) de charge ou pour détecter une grandeur déduite dudit flux de courant.

12. Circuit (37) série suivant la revendication 11,
**caractérisé en ce que** chaque capteur (22, 29) de mesure est conçu pour détecter le flux de courant sur une borne (4, 5) de charge associée.

13. Circuit (37) série suivant l'une des revendications 10 ou 11,
**caractérisé en ce que**
les moyens (22, 23, 24, 27, 29, 30) de détection d'une répartition dissymétrique du courant comportent une culasse (27, 30) à magnétisme doux et au moins un capteur (29) de mesure, qui est conçu pour détecter un champ magnétique dans la culasse (27, 30) à magnétisme doux.

14. Circuit (37) série suivant l'une des revendications 9 à 13,
**caractérisé en ce que**
les moyens de court-circuit ont un interrupteur (20) de court-circuit.

15. Circuit (37) série suivant l'une des revendications 9 à 14,
**caractérisé en ce que**
les moyens de court-circuit sont, au moins en partie, entre la plaque (18) d'émetteur et la plaque (16) de collecteur.

16. Circuit (37) série suivant la revendication 15,
**caractérisé en ce que**
la plaque (18) d'émetteur et la plaque (16) de collecteur forment un boîtier (25) de circuit, les moyens de court-circuit étant disposés, au moins en partie, dans le boîtier (25) de circuit.
